Europäisches Patentamt

European Patent Office

Office européen des brevets

(19)

(11) Veröffentlichungsnummer: **0 180 906**
**B1**

(12) **EUROPÄISCHE PATENTSCHRIFT**

(45) Veröffentlichungstag der Patentschrift:
**18.01.89**

(21) Anmeldenummer: **85113783.6**

(22) Anmeldetag: **29.10.85**

(51) Int. Cl.⁴: **H 01 L 23/56**

(54) **Wellenwiderstandsgetreuer Chipträger für Mikrowellenhalbleiter.**

(30) Priorität: **02.11.84 DE 3440171**

(43) Veröffentlichungstag der Anmeldung:
**14.05.86 Patentblatt 86/20**

(45) Bekanntmachung des Hinweises auf die Patenterteilung:
**18.01.89 Patentblatt 89/3**

(84) Benannte Vertragsstaaten:
**DE FR GB**

(56) Entgegenhaltungen:
**EP-A- 0 018 174**
**EP-A- 0 026 788**
**FR-A- 2 284 195**
**GB-A- 2 007 911**
**US-A- 3 590 341**
**US-A- 4 266 239**

**IBM TECHNICAL DISCLOSURE BULLETIN, Band 21, Nr. 5, Oktober 1978, Seiten 1895-1897, New York, US; S. MAGDO: "Low inductance module"**

(73) Patentinhaber: **Siemens Aktiengesellschaft Berlin und München, Wittelsbacherplatz 2, D-8000 München 2 (DE)**

(72) Erfinder: **Platzöder, Karl, Dr. rer. nat., Grete-Hoffmann-Weg 22, D-8048 Halmhausen (DE)**
Erfinder: **Zimmermann, Walter, Ing. grad., Eichenweg 9, D-8250 Dorfen 1/Oberdorfen (DE)**

## Beschreibung

Die Erfindung betrifft einen Chipträger für Mikrowellenbauteile nach dem Oberbegriff des Anspruchs 1.

Für Mikrowellenhalbleiter, beispielsweise für integrierte Galliumarsenid-Mikrowellen-Chips werden wellenwiderstandsgetreue Gehäuse benötigt. Bei der Kapselung von Mikrowellen-Halbleiter-Chips in ein Gehäuse bzw. bei der Aufnahme von Mikrowellen-Halbleiter-Chips auf einen Chipträger sollen optimale Mikrowelleneigenschaften, gute Wärmeableitung, volle Prüfbarkeit und einfache Einsetzbarkeit beim Kunden erzielt werden.

Wird ein Halbleiterchip ohne Verwendung eines Chipträgers direkt in eine Schaltung montiert, so ist dieser Halbleiterchip vor der Direktmontage in diese Schaltung nur eingeschränkt prüfbar. Daraus resultiert eine relativ hohe Ausfallquote bei einem solchen Halbleiterchip.

Aus der US-Patenschrift 4 115 837 ist ein Chipträger für eine integrierte Schaltung bekannt. Dabei ist die integrierte Schaltung auf ein isolierendes Material aufgebracht. Damit möglichst viele elektrische Verbindungen mit der integrierten Schaltung untergebracht werden können, ragt das isolierende Substrat in derjenigen Fläche, in der es auf einem Träger befestigt ist, über diesen Träger hinaus. Ein solcher Träger ist für Mikrowellenanwendungen nicht vorgesehen. Für Testzwecke ist am Aussenrand der Unterseite des isolierenden Substrats eine Metallisierung angebracht. Diese nicht vollflächige Metallisierung stört die Übertragung von Mikrowellen. Nur um einen Test durchführen zu können, gibt es bei diesem Chipträger eine kompliziert aufgebaute elektrische Verbindung zwischen dem Chip und dieser Metallisierung an der Unterseite des isolierenden Substrats. Ausser für Testzwecke verläuft die Masseleitung des Chips nicht über die Unterseite des isolierenden Substrats.

Aus der US-Patentschrift 4 340 902 ist ein Chipträger bekannt, bei dem zur besseren Wärmeableitung der Chip auf ein Metallstück aufgesetzt ist. Über eine kompliziert aufgebaute Masseleitung, die durch eine Vielschicht-Keramik-Struktur hindurchführt, ist der Chip mit einer metallischen Platte verbunden, die zwischen der Unterlage des Chips und dem Träger angeordnet ist. Der Aufbau dieses Chipträgers ist kompliziert und nicht für beliebige Mikrowellenbauelemente auf beliebigen Platinen flexibel anpassbar.

Aus der US-Patentschrift 3 864 727 ist ein Chipträger bekannt, bei dem der Chip auf ein isolierendes Substrat aufgesetzt ist. Dieses isolierende Substrat ist seinerseits auf einen metallischen Träger aufgebracht, der in derjenigen Fläche, in der das Substrat aufliegt, wesentlich über das Substrat hinausragt. Ein solcher Chipträger hat breite Streifenleitungen, ist nicht auf Platinen aufsetzbar und ist von der Konstruktion her nicht für Mikrowellenschaltungen geeignet.

Aus der US-Patentschrift 3 946 428 ist ein Chipträger bekannt, bei dem der Chip in einer Aussparung eines dielektrischen Substrats auf ein metallisches Zwischenstück aufgesetzt ist, das seinerseits auf den metallischen Träger aufgesetzt ist. Der metallische Träger hat dabei dieselben äusseren Abmessungen wie das dielektrische Substrat. Eine Wellenwiderstandsanpassung erfolgt über zusätzliche dielektrische Unterlagen. Dadurch wird der Aufbau kompliziert, der nur eine geringe Anzahl von Streifenleitungen zulässt.

Aus der US-Patentschrift 3 769 560 ist ein Chipträger bekannt, der kompliziert aufgebaut ist und bei dem für elektrische Masseleitungen besondere elektrische Verbindungen erforderlich sind. Ein solcher Chipträger ist für Mikrowellenanwendungen nicht besonders geeignet.

Aus der US-Patentschrift 3 590 341 ist ein Chipträger bekannt, bei dem bei Einbau eines Transistors aus Symmetriegründen zwei elektrische Zuleitungen zum Emitter des Transistors notwendig sind. Diese gesonderten Zuleitungen zum Emitter des Transistors erfordern viel Platz nicht nur auf dem Chipträger, sondern auch auf einer Platine, auf welcher der Chipträger angeordnet werden soll, und sind ebenso materialaufwendig. Die Wärmeableitung ist bei diesem Chipträger ebenso schlecht.

Aus der US-Patentschrift 3 651 434 ist ein Chipträger bekannt, bei dem ein dielektrisches Substrat auf einen Träger aufgesetzt ist. Innerhalb einer Aussparung des dielektrischen Substrats ist ein Mikrowellenbauelement auf den Träger aufgebracht. Zwischen dem dielektrischen Substrat und dem Träger ist mindestens ein Bereich vorgesehen, in dem der Träger mit einer Metallisierung überzogen ist. Diese Metallisierung erstreckt sich in derjenigen Fläche, in der das dielektrische Substrat auf dem Träger aufliegt, über die Abmessungen des dielektrischen Substrats bei weitem hinaus. Das dielektrische Substrat ist relativ dick. Daher müssen die elektrischen Anschlüsse in ihrem gesamten Verlauf relativ dick sein, was nur eine geringe Packungsdichte von elektrischen Leitungen zulässt. Ein solcher Aufbau eines Chipträgers ist nicht nur kompliziert, sondern ist auch für Mikrowellenanwendungen nicht besonders günstig. Insbesondere ist es zumindest in einfacher Weise nicht möglich, einen solchen Chipträger mit seinen elektrischen Anschlüssen an verschiedene Verwendungszwecke, insbesondere an verschiedene Anwenderschaltungen, anzupassen.

Der vorliegenden Erfindung liegt die Aufgabe zugrunde, einen Chipträger der eingangs genannten Art anzugeben, dessen elektrische Zuleitungen in einfacher Weise impedanzangepasst werden können, der optimale Mikrowelleneigenschaften aufweisen kann, der eine gute Wärmeableitung besitzt, der in einfacher Weise eine Prüfbarkeit des einen Halbleiter tragenden Chipträgers zulässt, der beim Kunden einfach eingesetzt werden kann, der einen einfachen Aufbau aufweist und der eine hohe Packungsdichte von elektrischen Mikrowellenleitungen grundsätzlich ermöglicht.

Diese Aufgabe wird erfindungsgemäss durch einen Chipträger nach dem Anspruch 1 gelöst.

Das dielektrische Substrat ist vorteilhafterweise ein Keramikplättchen.

Da das dielektrische Substrat in derjenigen Fläche, in der es auf den Träger aufgesetzt ist, über diesen Träger übersteht, können dort, wo das dielektrische Substrat den Träger überragt, in einfacher Weise die Mikrostreifenleiter des Chipträgers derart verbreitet und/oder verdickt werden, dass eine wellenwiderstandsrichtige Anpassung an das verwendete Material, auf das der Chipträger aufgesetzt werden soll, möglich ist.

Wird für wenigstens einen elektrischen Anschluss des Chipträgers ein Anschlussbändchen verwendet, so gibt es beim Aufsetzen des Chipträgers, beispielsweise auf eine Masterplatine, praktisch keine Stosskante. Eine Reflexion einer Mikrowelle wird dadurch vermieden. Dasselbe gilt bei einem Chipträger nach der Erfindung für den Fall, dass wenigstens eine Anschlusskante metallisiert ist.

Bei einem Chipträger nach der Erfindung kann der Träger vollständig metallisch sein. Der Träger kann jedoch auch metallisiert sein. Diese Metallisierung muss sich nicht über die gesamte Oberfläche des Trägers erstrecken. Wichtig ist dabei, dass die Metallisierung in ihrem wesentlichen Ausmass sich nicht in der Nähe derjenigen Orte befindet, wo die Mikrostreifenleiter verbreitert und/oder verdickt sind. Wichtig ist dabei, dass die Metallisierung des Trägers ein solches Ausmass annimmt, dass die Masseleitungen des Halbleiters über diese Metallisierung elektrisch mit der Masse einer Anwenderschaltung verbunden werden kann. Gleichzeitig soll über diese Metallisierung auch noch Wärme abgeführt werden können. Je nachdem, wieviel Wärme bei dem verwendeten Halbleiter anfällt, kann die Metallisierung bzw. kann die metallische Eigenschaft des Trägers angepasst werden.

Ein Chipträger nach der Erfindung ermöglicht eine kurze Masseleitung. Ein Chipträger nach der Erfindung ermöglicht eine geringe Induktivität des Masseanschlusses.

Weitere Vorteile der Erfindung sind in der Beschreibung und der Zeichnung dargestellt.

Ausführungsbeispiele der Erfindung werden im folgenden anhand der Zeichnung näher beschrieben.

Die Fig. 1 und 2 zeigen einen Chipträger nach der Erfindung.

Die Fig. 3 und 4 zeigen einen Chipträger nach der Erfindung nach dem Einbau in eine Mikrostreifenleitungsschaltung.

Fig. 5 erläutert bevorzugte Abmessungen und Materialien für einen Chipträger nach der Erfindung.

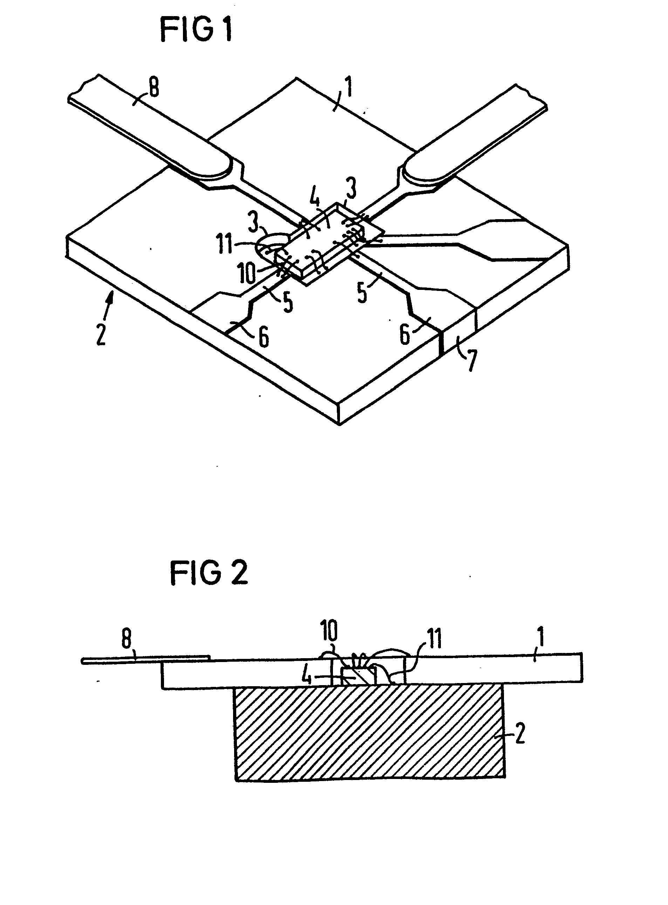

Die Fig. 1 und 2 zeigen einen Chipträger nach der Erfindung. Ein mit Miktrostreifenleitungen 5 (Anschlussleitungen) und mit einer formvariablen Aussparung 3 versehenes dielektrisches Trägerplättchen 1 ist mit einem leitenden Träger 2 derart verbunden, dass durch die Aussparung 3 der Träger 2 zugänglich ist. Der Träger ist vorzugsweise als zylindrischer Metallbolzen ausgeführt. In die Aussparung 3 wird auf den Träger 2 ein Halbleiterchip 4 mit seinen Masseanschlüssen 11 aufgebracht. Die übrigen Anschlüsse 10 des Halbleiterchips 4 führen auf die Mikrostreifenleitungen 5, mit denen das dielektrische Substrat 1 versehen ist.

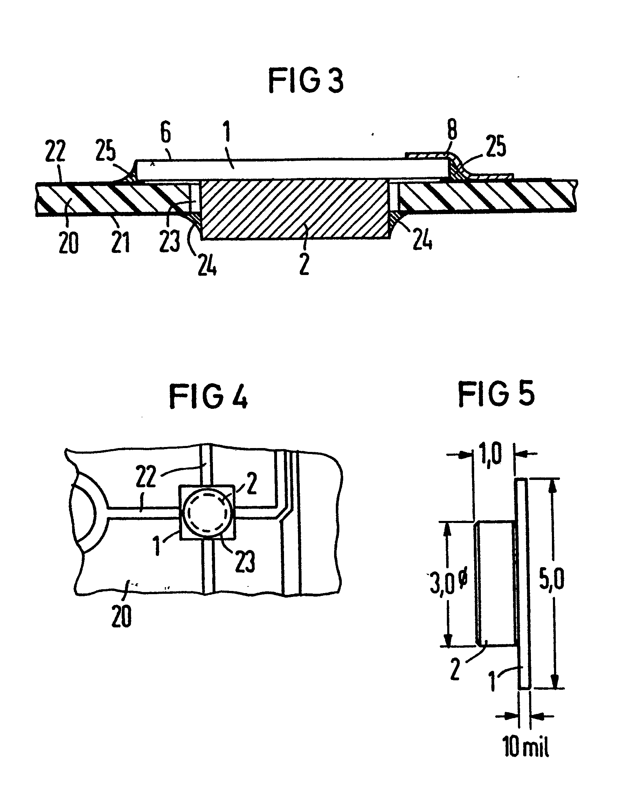

Die Abmessungen des Trägers 2 liegen in derjenigen Fläche, in der das dielektrische Substrat 1 auf dem Träger 2 angeordnet ist, innerhalb der Abmessungen des dielektrischen Plättchens 1. Die den Träger 2 in derjenigen Auflagefläche, in der das dielektrische Substrat 1 auf dem Träger 2 angeordnet ist, überragenden Mikrostreifenleiter 6 sind derart verbreitert, dass eine wellenwiderstandsrichtige Anpassung an das verwendete Material der Masterplatine 20 (siehe Fig. 3 und 4), auf welche der Chipträger aufgesetzt wird, gegeben ist. Als Masterplatine 20 kann z. B. Teflon RT Duroid 5880, 0,38 mm verwendet werden. Es kann auch eine Platine aus Keramik verwendet werden. Die Anschlusskanten 7 des Chipträgers können metallisiert sein. Der Chipträger kann jedoch auch mit Anschlussbändchen 8 versehen sein. Bei der Verwendung von Anschlussbändchen 8 oder bei einer Metallisierung von Anschlusskanten können Stosskanten vermieden werden.

Eine Abdeckung des Halbleiters 4 bzw. eine hermetische Kapselung des Halbleiters 4 mit Methoden, die dem Fachmann aus der zitierten Literatur bekannt sind, ist möglich.

Die Fig. 3 und 4 zeigen einen Chipträger, nachdem er in eine Mikrostreifenleitungsschaltung montiert worden ist. Diese Montage erfolgt dabei durch Aufsetzen des Chipträgers auf eine Masterplatine 20. Zur Montage wird der Träger 2 (Metallbolzen) des Chipträgers in eine Aussparung 23 der Mikrostreifenleitungsschaltung 20 eingesetzt und rückseitig elektrisch mit der Masse 24 verbunden. Die übrigen Anschlüsse 25 des Chipträgers erfolgen auf der Oberseite der Masterplatine 20.

Stossstellen zwischen Mikrostreifenleitungen des Chipträgers und Mikrostreifenleitungen der Masterplatine können, wenn es schaltungstechnisch erwünscht ist, so gering wie möglich gehalten werden. Die elektrischen Verbindungen 24, 25 können zu diesem Zweck durch Kleben oder durch Löten hergestellt werden. Auf diese Weise ist es möglich, wie in Fig. 3 dargestellt, dass sowohl bei Verwendung einer Herabmetallisierung 7 auf dem Chipträger als auch bei Verwendung eines Anschlussbändchens 8 (Anschlusslead) elektrische Anschlüsse zwischen dem Chipträger und der Mikrowellenstreifenleitungsschaltung auf der Masterplatine hergestellt werden, die praktisch keine Stosskante aufweisen. Dadurch wird eine Reflexion einer Mikrowelle vermieden.

Auf der Rückseite der Masterplatine 20 wird eine elektrische Verbindung zwischen einem metallisierten Bereich des Trägers 2 und der Rückseitenkaschierung 21 der Masterplatine 20 hergestellt. Auf der Oberseite der Masterplatine 20 werden elektrische Verbindungen zwischen den elektrischen Anschlüssen des Chipträgers und einzelnen Mikrostreifenleitungen 22 hergestellt.

Bei Verwendung eines Anschlussbändchens 8 auf dem Chipträger kann metallischer Kleber oder Lot zwischen dem entsprechenden Teil der Kante des Chipträgers und einer Mikrostreifenleitung 22 auf der Masterplatine 20 so angebracht werden, dass das Anschlussbändchen 8 in einfacher Weise durch Biegen sowohl mit dem metallischen Kleber bzw. mit dem metallischen Lot als auch mit der Mikrostreifenleitung 22 auf der Masterplatine 20 verbunden ist.

Fig. 4 zeigt eine Draufsicht auf die Masterplatine (Mikrostreifenleitungsschaltung) 20, auf die der Chipträger aufgesetzt ist. Der Träger 2 des Chipträgers passt gerade in die Aussparung 23 der Masterplatine 20. Die Aussparung 23 ist auf der Masterplatine 20 so angeordnet, dass die Mikrostreifenleitungen 6 vom Chipträger in einfacher Weise mit den Mikrostreifenleitern 22 der Masterplatine 20 verbunden werden können.

Fig. 5 zeigt bevorzugte Abmessungen und Materialien für den Chipträger. Das dielektrische Substrat 1 des Chipträgers besteht bevorzugt aus Aluminiumoxid ($Al_2O_3$) und ist bevorzugt 0,25 mm (10 mil) stark. Das dielektrische Substrat 1 kann beispielsweise einen Durchmesser oder eine lineare Abmessung in jeder der beiden Richtungen senkrecht zur Chipträgerachse von 5,0 mm aufweisen. Der Träger 2 des Chipträgers ist bevorzugt ein zylindrischer Metallbolzen. Der Träger 2 hat bevorzugt einen Durchmesser von 3,0 mm und eine Höhe von 1,0 mm.

Die Verwendung eines metallischen Trägers 2 hat den Vorteil, dass bei einem unmittelbar auf den Metallträger 2 montierten Bauteil 4 die Wärmeableitung optimiert werden und dass gleichzeitig eine Masseverbindung erzeugt werden kann, die sehr niederohmig ist. Die Verwendung eines metallisierten Trägers 2 hat hingegen Vorteile hinsichtlich der Anpassung der thermischen Ausdehnungskoeffizienten der aneinander angrenzenden Materialien.

Durch die Anpassung der Aussparungen 3 nach Form und Grösse an die Erfordernisse verschiedener Bauteile lassen sich die Verbindungsleitungen zwischen den Chipbauteilen einerseits und den Mikrostreifenleitungen bzw. dem metallischen oder metallisierten Träger 2 andererseits so kurz wie möglich halten.

Da das dielektrische Substrat direkt auf dem Träger 2 aufliegt, kann das dielektrische Substrat 1 sehr dünn gehalten werden Dies hat den Vorteil, dass die Mikrostreifenleitungen auch bei Frequenzen bis 30 GHz nur mit geringen Weiten ausgeführt werden müssen, so dass bei einer vorgegebenen Anzahl von Mikrostreifenleitungen die Aussparung 3 entsprechend klein gehalten werden kann. Daraus resultieren wiederum kurze Verbindungsleitungen zwischen den Chipkontakten und den Mikrostreifenleitungen bzw. dem Träger 2, was zu einer Verkleinerung der Gesamtimpedanz führt.

Der Chipträger ist insbesondere für integrierte Mikrowellenschaltungen geeignet. Da die Chipkontakte, Mikrostreifenleitungen und auch der metallische bzw. metallisierte Träger 2 vor einer eventuellen Kapselung zugänglich sind, lassen sich Mikrowellenbauteile, die bereits in den Chipträger eingebaut sind, leicht vermessen, testen oder abgleichen. Der Chipträger ist vielseitig anwendbar, da er sich für verschiedene Bauteile, Bauteilgruppen und Schaltungen anwenden lässt. Schliesslich lässt sich ein solcher Chipträger durch Anbringen einer Abdeckkappe oberhalb des Substrats 1 leicht hermetisch abschliessen.

Dass die Aussparung 3 form- und grössenangepasst ist, bedeutet in diesem Zusammenhang, dass diese Aussparung 3 für die individuellen Bedürfnisse und Anforderungen jedes auf den Chipträger aufzubringenden Mikrowellenbauteils nach Form und Grösse variiert werden kann. Bei der Verwendung eines metallisierten Trägers 2 wird das Material des Substrats 1 so ausgewählt, dass diese Materialien annähernd gleiche thermische Ausdehnungskoeffizienten besitzen. Beispielsweise kann für den Träger 2 dasselbe Material mit einem Metallüberzug versehen werden, wie es für das Substrat 1 verwendet wird.

Der Chipträger kann durch eine Abdeckung hermetisch dicht verschlossen sein. Die Abdeckung kann aus einer dielektrischen Vergussmasse oder aus einem dielektrischen Deckel bestehen.

Die Mikrostreifenleitungen können wellenwiderstandsgetreu beispielsweise an 50 Ohm angepasst werden. Die Weite der Mikrostreifenleitungen kann bis zu 5 mm, insbesondere zwischen 0,1 mm und 1 mm betragen. Das dielektrische Substrat 1 hat bevorzugt eine Stärke zwischen 0,1 mm und 0,5 mm, insbesondere von 0,25 mm = 10 mil. Der Träger 2 soll bevorzugt so dick sein, dass die elektrischen Anschlüsse 24 zu einer Mikrostreifenschaltung 20 noch bequem hergestellt werden können.

Mikrostreifenleiter können auf dem dielektrischen Substrat 1 z.B. mittels Bedampfen mit Aluminium und mittels einer nachfolgenden strukturierten Ätzung der Aluminiumschicht erzeugt werden. Die so hergestellten Aluminiumstrukturen stellen Mikrostreifenleitungen dar. Mikrostreifenleiter können auch in Dickfilmtechnik hergestellt werden.

Zusätzlich und/oder alternativ zum Halbleiterchip 4 können aktive oder passive Miktrowellenbauteile auf dem Substrat 1, und zwar auf reinen Substratoberflächenteilen oder auf Mikrostreifenleitungen aufgebracht werden.

Ein Substrat 1 kann auch mehrere Träger 2 aufweisen. Ein dielektrisches Substrat 1 kann auch mehrere Aussparungen 3 aufweisen. Es können auch mehrere Chipbauteile 4 in eine Aussparung 3 eingesetzt werden.

Die beanspruchte Verdickung eines Mikrowellenstreifenleiters auf dem dielektrischen Substrat 1 kann durch Variation von Höhe und/oder Breite des Mikrowellenstreifenleiters erfolgen.

Wichtig für die Erfindung ist, dass die Anpassung des Wellenwiderstands eines Mikrowellenstreifenleiters auf dem dielektrischen Substrat 1 an die Anschlüsse einer Schaltung, in der der Chipträger verwendet werden soll, auf dem dielektrischen Substrat 1 ausserhalb desjenigen Bereichs vorgenommen wird, in dem sich unterhalb des dielektrischen Substrats 1 metallisches Material befindet. Ein so ausgestalteter Chipträger kann eine optimal geringe Gesamtimpedanz besitzen.

Die wellenwiderstandsgetreue Anpassung der Mikrostreifenleitungen kann rechnerisch oder empirisch erfolgen. Die dann erforderlichen Verdikkungen der Mikrostreifenleiter hängen in ihrer Geometrie ab von Material und Gestalt des Trägers 2, des Substrats 1, der Platine 20, von den unterschiedlichen relativen Dielektrizitätskonstanten, den unterschiedlichen Laufzeiten der Mikrowellen, den Streufeldern, den unterschiedlichen Arten von Mikrowellenleitungen auf Substrat 1 und Platine 20. Beim Übergang einer elektrischen Verbindung vom Chipträger zur Platine 20 darf kein Wellenwiderstandssprung vorhanden sein.

Das dielektrische Substrat 1 kann grundsätzlich beliebige Formen annehmen, beispielsweise eine Kreis-, eine Quadrat-, eine Rechteck- usw. form.

Der beschriebene Chipträger hat nicht nur wellenwiderstandsangepasste Streifenleiter, sondern ist auch flexibel für beliebige Halbleiterbauelemente und für beliebige Materialien von Mikrowellenleitungsschaltungen anpassbar. Ein dünnes Substrat 1 ermöglicht schmale Streifenleitungen, wodurch eine hohe Packungsdichte von elektrischen Leitungen um die Aussparung 3 herum erzielt werden kann, was für integrierte Schaltungen und/oder für Hybridschaltungen, die innerhalb der Aussparung 3 angeordnet werden können, von Bedeutung ist, wobei gleichzeitig eine geringe Kopplung zwischen eng benachbarten Leitungen auf dem dielektrischen Substrat 1 vorhanden ist.

Auf dem Chipträger kann schliesslich eine individuell an das jeweilige Platinenmaterial und an den Chipträger wellenwiderstandsangepasste Spinne (lead frame) angebracht (beispielsweise angelötet) werden. Die individuelle Anpassung der Spinne kann dabei über unterschiedlich ausgestaltete Geometrien der Spinnenfinger erzielt werden.

Da bei einer Spinne keine engen Toleranzen realisierbar sind, ist die vorgesehene wellenwiderstandsmässige Anpassung der Mikrostreifenleiter auf dem dielektrischen Substrat 1 von Vorteil, weil solche Mikrostreifenleitungen beispielsweise mittels Dickfilmtechnik mit engen Toleranzen hergestellt werden können.

Die Vorteile des beschriebenen Chipträgers liegen in seiner einfachen Herstellbarkeit und in seiner einfachen Einsetzbarkeit. Da der Träger 2 einen relativ kleinen Durchmesser hat, ist die Aussparung 23 für den Träger 2 innerhalb der Platine 20 gut positionierbar.

Wenn der Träger 2 als Hohlbolzen gefertigt ist, besitzt er eine geringere Wärmekapazität und ist deshalb leichter lötbar.

Für den beschriebenen Chipträger können in einfacher Weise Spinnen so angefertigt werden, dass der beschriebene Chipträger mit nur wenigen Bautypen universell für sehr viele verschiedene Anwendungen, und zwar bis zu 30 GHz hin, einsetzbar ist.

Wichtig bei dem beschriebenen Chipträger ist ein möglichst dünnes dielektrisches Substrat 1. Ein solches dielektrisches Substrat 1 ermöglicht eine hohe Packungsdichte von Streifenleitungen 5, ohne dass Kopplungen zwischen diesen Streifenleitungen stören würden. Da das dielektrische Substrat 1 über den Träger 2 in derjenigen Fläche hinausragt, in der die Streifenleitungen 5 angeordnet sind, können ausserhalb des zum Träger 2 gehörenden Metalls die Streifenleitungen 5 zu den Streifenleitungen 6 verdickt werden. Die in der Höhe und/oder in der Breite verdickten Streifenleiter 6 sind mechanisch sehr stabil und sind bereits so breit, dass Weiterführungen über eine Spinne oder direkt an Streifenleiter einer Platine angefügt werden können, ohne dass an die mechanischen Toleranzen dieser Weiterführungen besonders hohe Anforderungen gestellt werden müssen. Dadurch wird der Einsatz des beschriebenen Chipträgers noch einfacher und billiger.

**Patentansprüche**

1. Chipträger für Mikrowellenbauteile mit mindestens einem, in einem einzigen Bereich elektrisch leitfähigen Träger mit mindestens einem dielektrischen Substrat, das mit leitenden Flächen und mit mindestens einer Aussparung versehen ist, in die mindestens ein aktives oder passives Mikrowellenbauteil eingesetzt ist, dadurch gekennzeichnet, dass die Aussparung (3) im dielektrischen Substrat (1) in Form und Grösse an die Erfordernisse des Mikrowellenbauteils angepasst ist, dass das dielektrische Substrat (1) auf dem, in einem einzigen Bereich elektrisch leitfähigen Träger (2) aufliegt, dass das Mikrowellenhalbleiterbauelement (4) in der Aussparung (3) des dielektrischen Substrats (1) eingesetzt ist, dass die Masseanschlüsse (11) des Mikrowellenhalbleiterbauelements (4) innerhalb der Aussparung (3) mit dem elektrisch leitfähigen Bereich des Trägers (2), der sich unterhalb der betreffenden Aussparung (3) befindet, verbunden sind, dass das dielektrische Substrat (1) in derjenigen Fläche, in der es auf dem Träger (2) aufliegt, grössere Abmessungen als der elektrisch leitfähige Bereich des Trägers (2) aufweist, dass die elektrisch leitenden Flächen auf dem dielektrischen Substrat (1) Mikrowellenstreifenleitungen (5) sind und dass diese Mikrowellenstreifenleitungen (5) dort, wo das dielektrische Substrat (1) in seinen Abmessungen über die Abmessungen des elektrisch leitfähigen Bereichs des Trägers (2) hinausragt, Verdickungen und/oder Verbreiterungen (6) zur elektrischen Anpassung an äussere Materialien aufweisen, auf die der Chipträger später aufgesetzt wird.

2. Chipträger nach Anspruch 1, dadurch gekennzeichnet, dass mindestens eine Anschlusskante (7) des Chipträgers metallisiert ist.

3. Chipträger nach Anspruch 1 oder 2, gekennzeichnet durch mindestens ein Anschlussbändchen (8).

4. Chipträger nach einem der Ansprüche 1 bis 3, dadurch gekennzeichnet, dass mindestens ein Mikrowellenhalbleiterbauelement, (4) abgedeckt ist.

5. Chipträger nach einem der Ansprüche 1 bis 4, dadurch gekennzeichnet, dass das Mikrowellenhalbleiterbauelement, (4) hermetisch gekapselt ist.

6. Chipträger nach einem der Ansprüche 1 bis 5, dadurch gekennzeichnet, dass das dielektrische Substrat (1) aus Keramik besteht.

7. Chipträger nach einem der Ansprüche 1 bis 6, dadurch gekennzeichnet, dass mindestens ein dielektrisches Substrat (1) eine Dicke zwischen 0,05 mm und 0,5 mm aufweist.

8. Chipträger nach einem der Ansprüche 1 bis 7, dadurch gekennzeichnet, dass mindestens ein Träger (2) wenigstens teilweise metallisiert ist.

9. Chipträger nach einem der Ansprüche 1 bis 8, dadurch gekennzeichnet, dass das dielektrische Substrat (1) eine relative Dielektrizitätskonstante zwischen 4 und 12 aufweist.

10. Chipträger nach einem der Ansprüche 1 bis 9, dadurch gekennzeichnet, dass die verdickten Streifenwellenleiter (6) eine Breite bis zu 5 mm aufweisen.

11. Chipträger nach einem der Ansprüche 1 bis 10, dadurch gekennzeichnet, dass die nicht verdickten Streifenwellenleiter (5) eine Breite bis zu 1 mm aufweist.

**Claims**

1. Chip support for microwave components having at least one support which is electrically conductive in a single area, having at least one dielectric substrate which is provided with conductive surfaces and with at least one recess into which at least one active or passive microwave component is inserted, characterized in that the recess (3) in the dielectric substrate (1) is matched in shape and size to the requirements of the microwave component, that the dielectric substrate (1) rests on the support (2) which is electrically conductive in a single area, that the microwave semiconductor component (4) is inserted in the recess (3) of the dielectric substrate (1), that the earth connections (11) of the microwave semiconductor component (4) within the recess (3) are connected to the electrically conductive area of the support (2), which is located underneath the recess concerned (3), that the dielectric substrate (1) exhibits in the area in which it rests on the support (2) greater dimensions than the electrically conductive area of the support (2), that the electrically conductive surfaces on the dielectric substrate (1) are microwave striplines (5) and that these microwave striplines (5) exhibit thickened and/or widened sections (6) where the dimensions of the dielectric substrate (1) project over the dimensions of the electrically conductive area of the support (2), for electrical matching to external materials onto which the chip support will be placed later.

2. Chip support according to claim 1, characterized in that at least one connection edge (7) of the chip support is metallized.

3. Chip support according to claim 1 or 2, characterized by at least one small connection band (8).

4. Chip support according to one of claims 1 to 3, characterized in that at least one microwave semiconductor component (4) is covered over.

5. Chip support according to one of claims 1 to 4, characterized in that the microwave semiconductor component (4) is hermetically encapsulated.

6. Chip support according to one of claims 1 to 5, characterized in that the dielectric substrate (1) consists of ceramics.

7. Chip support according to one of claims 1 to 6, characterized in that at least one dielectric substrate (1) exhibits a thickness of between 0,05 mm and 0,5 mm.

8. Chip support according to one of claims 1 to 7, characterized in that at least one support (2) is at least partially metallized.

9. Chip support according to one of claims 1 to 8, characterized in that the dielectric substrate (1) exhibits a relative dielectric constant of between 4 and 12.

10. Chip support according to one of claims 1 to 9, characterized in that the thickened strip waveguides (6) exhibit a width of up to 5 mm.

11. Chip support according to one of claims 1 to 10, characterized in that the strip waveguides (5) which are not thickened exhibit a width of up to 1 mm.

**Revendications**

1. Support de puce pour des composants pour micro-ondes, avec au moins un support électriquement conducteur dans une zone unique, avec au moins un substrat diélectrique qui est pourvu de surfaces conductrices et d'au moins un évidement dans lequel est inséré au moins un composant pour micro-ondes du type passif ou actif, caractérisé par le fait que l'évidement (3) ménagé dans le substrat diélectrique est adapté, en forme et en dimensions aux exigences du composant pour micro-ondes, que le substrat diélectrique (1) repose sur le support (9) électriquement conducteur dans une zone unique, que le composant semiconducteur pour micro-ondes (4) est inséré dans l'évidement (3) ménagé dans le substrat diélectrique (1), que les bornes de masse (11) du composant semiconducteur pour micro-ondes (4) sont reliées à l'intérieur de l'évidement avec la zone électriquement conductrice du support (2), qui se trouve en-dessous de l'évidement (3) en cause, que le substrat diélectrique (1), possède, dans la surface dans laquelle il repose sur le support (2), des dimensions égales à celles de la zone électriquement conductrice du support (2), que les surfaces électriquement conductrices sur le substrat diélectrique (1) sont des bandes conductrices (5) pour micro-ondes et que les bandes conductrices (5) pour micro-ondes présentent là où le substrat diélectrique (1) déborde par ses dimensions celles de la zone électriquement conductrice du support (2), des épaississements ou élargissements (6) pour l'adaptation électrique à des matériaux extérieurs, et sur lesquels le support de puce est ultérieurement placé.

2. Support de puce selon la revendication 1, caractérisé par le fait qu'au moins un bord de raccordement (7) du support de puce est métallisé.

3. Support de puce selon la revendication 1 ou 2, caractérisé par au moins une bandelette de raccordement (8).

4. Support de puce selon l'une des revendications 1 à 3, caractérisé par le fait qu'au moins un composant à semiconducteur pour micro-ondes (4) est recouvert.

5. Support de puce selon l'une des revendications 1 à 4, caractérisé par le fait que le composant pour micro-ondes (4) est hermétiquement encapsulé.

6. Support de puce selon l'une des revendications 1 à 5, caractérisé par le fait que le substrat diélectrique (1) est constitué par une céramique.

7. Support de puce selon l'une des revendications 1 à 6, caractérisé par le fait qu'au moins un substrat diélectrique (1), possède une épaisseur située entre 0,05 mm et 0,5 mm.

8. Support de puce selon l'une des revendications 1 à 7, caractérisé par le fait qu'au moins un support (2) est au moins partiellement métallisé.

9. Support de puce selon l'une des revendications 1 à 8, caractérisé par le fait qu'au moins le substrat diélectrique (1) possède une constante diélectrique comprise entre 4 et 12.

10. Support de puce selon l'une des revendications 1 à 9, caractérisé par le fait que les bandes conductrices des ondes (6), qui épaissies, ont une épaisseur allant jusqu'à 5 mm.

11. Support de puce selon l'une des revendications 1 à 10, caractérisé par le fait que les bandes conductrices des ondes (5), qui sont épaissies, ont une largeur allant jusqu'à 1 mm.

FIG 1

FIG 2

EP 0180906 B1

9

## FIG 3

## FIG 4

## FIG 5